# FASCICULE DE BREVET EUROPEEN

(11) **EP 2 231 893 B1**
(45) Date de publication et mention de la délivrance du brevet: **01.06.2011**
(21) Numéro de dépôt: 08851624.0
(22) Date de dépôt: 07.11.2008
(51) Int. Cl.: C23C 2/36, C23C 14/32, C23C 14/54, C23C 14/56

(54) **PROCÉDÉ ET INSTALLATION DE GALVANISATION PAR ÉVAPORATION PLASMA**
VERFAHREN UND SYSTEM ZUM GALVANISIEREN DURCH PLASMAVERDAMPFUNG
METHOD AND SYSTEM FOR GALVANIZING BY PLASMA EVAPORATION

(30) Priorité: 19.11.2007 BE 200700556
(43) Date de publication de la demande: 29.09.2010
(73) Titulaire: Industrial Plasma Services & Technologies - IPST GmbH, 8212 Neuhausen am Rheinfall (CH)
(72) Inventeur: VANDEN BRANDE, Pierre, CH-8224 Löhningen (CH)
(74) Mandataire: Callewaert, Koen
(86) Numéro de dépôt international: PCT/EP2008/065168
(87) Numéro de publication internationale: WO 2009/065745

(56) Documents cités:
- US-A1- 2001 032 782
- US-A1- 2002 046 943

## Description

### 1. Description générale de l'invention

L'invention est relative à un procédé et une installation de galvanisation par plasma de substrats en acier se présentant sous la forme de tôles, de poutrelles, de plaques, de profilés, de tous types de sections transversales, mais aussi de pièces disposées sur des supports, par exemple des crochets ou des paniers métalliques, transportés dans une zone de traitement à l'aide de dispositifs généralement quelconques tels qu'un banc de rouleaux, ou un système de transport par monorail.

Dans ce procédé, le substrat à traiter, après avoir été préalablement décontaminé par des techniques connues de dégraissage alcalin et de nettoyage à l'acide, suivi d'un rinçage et d'un séchage, ou encore décontaminé par abrasion mécanique, par exemple au moyen d'une machine de grenaillage, est introduit dans une installation de galvanisation par plasma, faisant l'objet de l'invention et fonctionnant à une pression de gaz inférieure à la pression atmosphérique. En général le système fonctionne sous argon à une pression comprise entre 0,0005 et 0,05 mbar (0.05 - 5 Pa).

L'installation est préférentiellement constituée d'un sas à vide pour l'introduction et éventuellement aussi la sortie des substrats à traiter, suivi des cuves à vide de traitement, et terminée par un sas à vide pour la sortie des substrats galvanisés, ou d'une cuve de stockage lorsque les substrats entrent et sortent par le sas à vide d'introduction des pièces à traiter. Dans ce dernier cas, le substrat se déplace d'abord dans un sens et puis dans le sens opposé à l'intérieur de l'installation pour retourner au sas à vide de cette dernière.

L'utilisation d'un ou de deux sas à vide pour l'introduction et la sortie des substrats permet de maintenir la zone où s'effectue le traitement constamment à l'abri de l'air, ce qui est fondamental pour un bon fonctionnement de ce procédé, notamment pour éviter la présence de toute interface oxydée entre l'acier et le zinc et ainsi assurer une adhérence optimale du revêtement de zinc à l'acier.

L'installation, suivant l'invention, comprend une ou plusieurs sections d'activation de la surface d'acier par érosion par bombardement d'ions. Différents dispositifs peuvent être envisagés pour effectuer ce traitement. Par exemple, un dispositif d'etching magnétron de l'acier faisant usage de miroirs magnétiques pour le confinement de la décharge autour du substrat à traiter tel que décrit dans le document WO 02/12591, ou une source à plasma inductive couplée à une accélération des ions produits par un générateur en courant continu en polarisant le substrat négativement par rapport à une anode lui faisant face, ou encore l'utilisation de canons à ions. Dans tous les cas, il faut pouvoir gérer la puissance du dispositif d'etching en fonction de l'aire du substrat d'acier défilant par unité de temps dans ce dispositif, en particulier couper l'alimentation de la source d'activation par plasma du substrat d'acier lorsque ce dernier n'est pas présent dans la zone de traitement. En effet, dans ce cas outre l'utilisation inutile d'énergie, il y a un risque d'endommager l'installation par chauffage de ses parois. Inversement, il faut pouvoir enclencher et progressivement augmenter la puissance de la source d'activation par plasma lorsqu'un substrat pénètre dans cette zone de traitement.

L'installation comprend également une ou plusieurs sections de galvanisation par évaporation par plasma de zinc. Ce procédé, déjà connu et décrit dans le document WO 02/16664, met en oeuvre un bac de rétention permettant de maintenir une certaine quantité de zinc à l'état liquide et de l'évaporer au moyen d'un plasma réalisé dans la vapeur de zinc en polarisant en moyenne négativement le zinc liquide par rapport à une contre-électrode qui constitue une anode. Le bac de rétention est alimenté en zinc liquide via un tube d'alimentation plongeant dans une réserve de zinc maintenue dans un four à vide situé dans une chambre à vide, isolée à tout passage de gaz vers la cuve à vide de galvanisation, et dans laquelle, par régulation de la pression de gaz, il est possible de régler le niveau de zinc liquide dans le bac de rétention situé dans la cuve à vide où s'opère la galvanisation. Le plasma réalisé dans la vapeur de zinc est généralement obtenu au moyen d'une décharge magnétron. La tension de vapeur de zinc au dessus du bac de rétention est fonction de la puissance électrique dissipée à la surface du zinc liquide et fixe le poids de zinc qu'il est possible de déposer par unité de temps sur le substrat d'acier. Cette tension de vapeur peut atteindre plusieurs mbar correspondant généralement à une masse de zinc évaporée de plusieurs kg / min. Il est donc indispensable, tel que déjà décrit dans le document WO 02/16664, de prévoir une enceinte de confinement aux parois chauffées pour éviter que la vapeur de zinc n'aille contaminer l'ensemble de l'installation en condensant sur toutes les surfaces froides, qui sont généralement à température ambiante, autres que le substrat. Des ouvertures d'entrée et de sortie sont prévues dans cette enceinte de confinement afin de permettre au substrat à revêtir de la traverser. Le revêtement de zinc s'obtient donc par condensation de la vapeur de zinc directement à l'état solide sur la surface froide du substrat qui traverse l'enceinte de confinement. La température de la surface du substrat est typiquement inférieure à 150°C.

Il est donc avantageux de pouvoir adapter la puissance électrique délivrée au plasma et dissipée, via bombardement d'ions issus du plasma, à la surface du zinc liquide dans le bac de rétention en fonction de l'aire du substrat d'acier défilant par unité de temps dans l'enceinte de confinement. En particulier, suivant l'invention, l'on coupe cette alimentation électrique lorsqu'aucun substrat n'est présent dans l'enceinte de confinement et, inversement, l'on enclenche et augmente progressivement la puissance électrique dissipée à la surface du zinc liquide lorsque le substrat pénètre l'enceinte de confinement. Ceci est fait de manière à, non seulement, assurer une épaisseur de zinc uniforme à la surface du substrat, mais surtout à limiter les pertes de zinc par les ouvertures d'entrée et de sortie de l'enceinte de confinement lorsqu' aucun substrat ne traverse l'enceinte de confinement. En effet, outre la perte économique en zinc et en énergie, la contamination en zinc peut gravement endommager l'installation de galvanisation par évaporation plasma si elle n'est pas contrôlée.

Il résulte de ce qui précède que les dispositifs de traitement de l'installation ont avantage à fonctionner suivant une séquence identique lors du passage du substrat dans l'un des dispositifs de traitement comprenant :
- Une mise sous tension du dispositif de traitement lorsque le substrat y pénètre ;
- Une augmentation de la puissance fournie au dispositif de traitement proportionnellement à l'aire du substrat traversant le dispositif de traitement jusqu'à ce que la puissance nominale de fonctionnement du procédé soit atteinte lorsque le substrat traverse totalement le dispositif de traitement ;
- Le maintien d'une puissance nominale de traitement constante dépendant de la vitesse de défilement du substrat, tant que le substrat traverse le dispositif de traitement de part en part ;
- La diminution de la puissance fournie au dispositif de traitement proportionnellement à l'aire du substrat dans le dispositif lorsque le substrat sort du dispositif et ne le traverse plus de part en part ;
- La coupure de l'alimentation électrique alimentant le dispositif de traitement en l'absence de substrat.

Cette séquence de mise en route, de maintien en régime de fonctionnement, puis de mise à l'arrêt de chaque dispositif de traitement au cours du passage d'un substrat à traiter, dans l'installation de galvanisation par évaporation plasma, permet d'empêcher la contamination et d'économiser l'énergie de l'installation, suivant l'invention.

Pour des raisons de flexibilité du fonctionnement de l'installation, on peut se servir du substrat à traiter comme déclencheur des différentes unités de traitement si au moins un détecteur de présence se situe à l'entrée et au moins un détecteur se situe à la sortie de chaque dispositif de traitement. L'installation, suivant l'invention, comprend donc un détecteur à l'entrée et à la sortie de chaque dispositif de traitement, c'est-à-dire en amont et en aval par rapport au sens d'avancement du substrat de chaque unité d'activation par plasma ou d'etching et de chaque enceinte de confinement correspondant à une unité de galvanisation par évaporation plasma.

Les substrats à traiter, ou les produits qui constituent ces substrats, étant de par la nature de l'application essentiellement de longueurs et de sections variables, peuvent être disposés avec plus ou moins de précision à l'entrée de l'installation dès qu'un sas d'entrée est libéré. Il convient de prévoir un système de régulation de l'avance des substrats dans l'installation, ainsi qu'un système de régulation du fonctionnement des divers dispositifs de traitement de l'installation asservi à l'avance de ces substrats. Ceci, afin d'éviter les problèmes déjà évoqués cidessus, comme, par exemple, contamination et perte d'énergie, mais aussi dans le but de donner un maximum de flexibilité au traitement de substrats de géométries différentes dans des conditions opérationnelles optimales. Cette régulation est indépendante du mode de transport des substrats à traiter, par exemple des substrats longs transportés sur des rouleaux ou suspendus entre des crochets et transportés par un système de roulement sur monorail, ou encore des pièces disposées dans des paniers transportés sur monorail au travers des différents dispositifs de traitement.

L'invention vise donc le fonctionnement indépendant de chaque dispositif de traitement asservi à la détection de l'avance des substrats traités par les détecteurs situés en amont et en aval de chacun de ces dispositifs de traitement.

La gestion indépendante des différents dispositifs de traitement, enclenchés et arrêtés lors du passage d'un substrat, peut avantageusement être mise en oeuvre par la gestion hiérarchique suivante de l'installation :
- Un programme maître permettant la mise de l'installation sous conditions de travail, sa remise à l'air pour entretien, et en fonctionnement, la gestion du ou des sas à vide et du déplacement des substrats en acier, à une vitesse de transport pour leur introduction et leur sortie rapide du ou des sas à vide de l'installation, et à une vitesse de traitement généralement plus faible lors du traitement des substrats dans les différents dispositifs de traitement de l'installation.
- Un programme esclave par dispositif de traitement activé par au moins deux détecteurs de présence d'un substrat, l'un situé à l'entrée du dispositif de traitement et l'autre situé à la sortie du dispositif de traitement. Les programmes esclaves étant asservis à un signal émis par le programme maître lorsque les conditions physiques requises au fonctionnement des procédés sont atteintes. Pratiquement, ce signal maître est obtenu lorsque la section de traitement de l'installation atteint partout la pression nominale d'argon qui est typiquement comprise entre 0,0005 et 0 ,05 mbar. Chaque programme esclave est caractérisé par une séquence similaire de gestion de la puissance électrique fournie, comme déjà évoqué précédemment : mise en fonctionnement, rampe d'augmentation de puissance jusqu'au régime de fonctionnement, maintien du régime de fonctionnement tant que le substrat est détecté par les détecteurs d'entrée et de sortie, rampe de diminution de la puissance couplée au dispositif, et coupure de puissance lorsqu'aucun substrat n'est plus détecté par les deux détecteurs.

Cette structure hiérarchique de la gestion de l'installation de galvanisation par évaporation plasma constitue un aspect particulier de la mise en oeuvre de l'installation, suivant l'invention.

Le grand avantage de cette gestion hiérarchique de l'installation de galvanisation pour laquelle chaque dispositif de traitement est mis en fonctionnement et arrêté de manière indépendante par un programme esclave lors de la détection du passage du substrat dans ce dispositif de traitement, est que l'on peut réduire les temps d'attente improductifs durant lesquels les substrats entrent et sortent de l'installation par son ou ses sas à vide d'entrée et de sortie sans modification du logiciel de gestion de l'installation, simplement en augmentant la capacité de pompage à vide du sas à vide d'entrée et/ou de sortie, ainsi que la vitesse de transport d'une zone de chargement vers le sas, ou inversement du sas à vide vers la zone de déchargement.

Lors de la gestion du transport du substrat en cours de traitement par le programme maître, il convient donc d'utiliser une vitesse de transport du substrat pour le déplacement du substrat de la zone de chargement vers un sas à vide, ou d'un sas à vide vers la zone de déchargement, la plus élevée possible et donc au moins supérieure à la vitesse de traitement utilisée lorsque les substrats traversent les différents dispositifs de traitement de l'installation.

### 2. Description des figures

D'autres détails et particularités de l'invention ressortiront de la description donnée ci-après à titre d'exemple non limitatif d'une forme de réalisation particulière de l'installation et du procédé suivant l'invention avec référence aux dessins annexés.
La figure 1 est une représentation schématique d'une ligne de galvanisation par évaporation plasma pour substrats en acier, suivant l'invention.
La figure 2 est une représentation schématique d'un exemple d'une partie de l'installation, suivant l'invention, comprenant trois dispositifs de traitement par plasma.
La figure 3 représente un arrangement typique comprenant un dispositif présentant une cuve à vide avec une source à ions et une cuve de transport.
La figure 4 représente deux dispositifs de galvanisation, chacun de ces dispositifs étant précédé par une cuve de transport et de pompage.

Dans les différentes figures, les mêmes chiffres de référence se rapportent à des éléments analogues ou identiques.

### 3. Description détaillée de l'invention

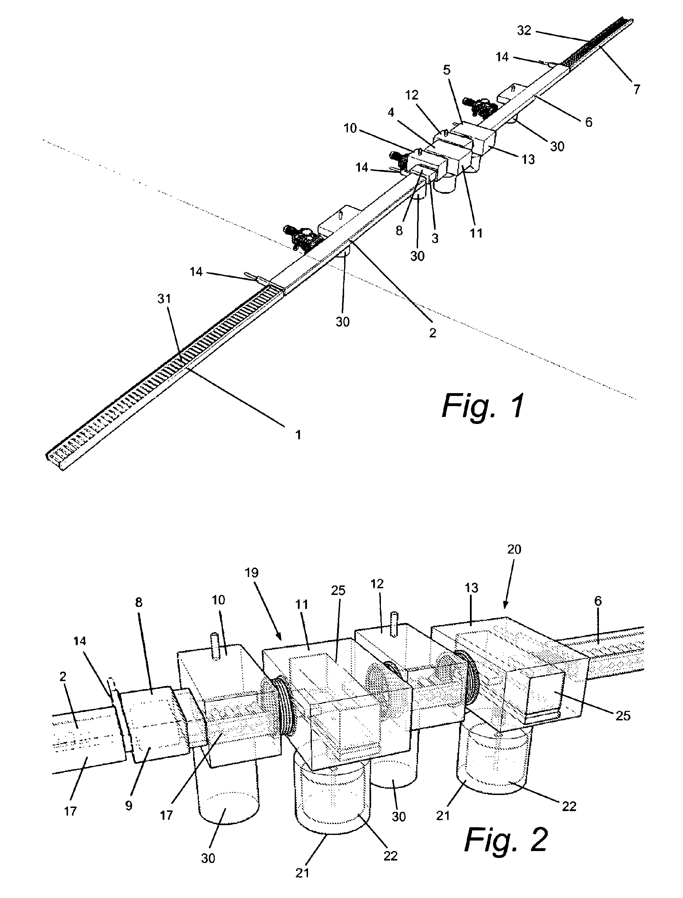

L'installation suivant l'invention comprend une ligne de galvanisation par évaporation plasma en batch et se compose essentiellement, comme représenté dans la figure 1 :
- d'une zone d'introduction 1 des substrats qui peut être, comme représenté sur la figure 1, constituée d'un banc de rouleaux permettant l'introduction de substrats longs tels que des poutrelles en acier. Le système de transport des substrats est un système de transport par bancs de rouleaux motorisés. Bien entendu d'autres systèmes de transport peuvent être envisagés tels qu'un système de transport par monorail permettant de suspendre les substrats et de les transporter depuis la zone 1 à travers les différentes autres zones de l'installation.
- d'un sas à vide d'entrée 2 qui permet de maintenir constamment une zone de traitement adjacente 3 sous vide sous la pression d'argon requise et évite ainsi de contaminer la zone de traitement par introduction d'air. La pression d'argon requise est typiquement entre 0,05 et 5 Pa.
- de plusieurs zones de traitement comprenant une zone d'activation plasma 3 du substrat et deux zones de galvanisation par plasma 4 et 5. Les zones 4 et 5 étant maintenues constamment, en régime de fonctionnement, sous pression partielle d'argon, de préférence entre 5.10⁻⁴ et 5.10⁻² mbar.
- d'un sas de sortie 6 permettant l'évacuation des substrats des zones de traitement 3, 4 et 5 vers une zone de sortie et de déchargement 7 en maintenant ces zones à l'abri de l'air.

Dans une forme de réalisation alternative de l'installation, suivant l'invention, le sas à vide d'entrée 2 sert aussi de sas à vide de sortie lorsque le substrat, après être entré entièrement dans les zones de traitement 3, 4 et 5, retourne dans le sas d'entrée 2 par inversion du sens de déplacement du système de transport. Dans ce cas, une cuve de stockage à vide peut être prévue à l'endroit du sas à vide de sortie 6 de la figure 1.

Il est évident que lorsque le traitement des substrats s'effectue dans un sens, de la zone d'introduction 1 vers les zones de traitement 3, 4 et 5, et ensuite dans l'autre sens, de ces zones de traitement 3, 4 et 5 vers la zone d'introduction 1, la zone de sortie et de déchargement 7 des substrats est inutile ce qui permet aussi, outre l'économie d'un sas et de cette zone de transport de substrat, la réalisation d'une installation de longueur plus courte.

La figure 2 représente un exemple typique d'éléments de traitement mis en oeuvre dans une installation de galvanisation par plasma. Les zones de traitement sont composées des éléments successifs suivants:
- Une cuve 8 équipée d'un dispositif d'activation par plasma 9 de la surface d'acier. Le substrat, qui n'est par représenté sur la figure, traverse cette cuve 8 en suspension libre.
- Une cuve 10 de pompage haut vide et de transport du substrat. Cette cuve 10 permet de maintenir la pression de travail d'argon dans les cuves d'activation 8 et de zingage 11 avoisinantes. Cette cuve 10 permet aussi de supporter et de faire avancer les substrats qui la traversent sur des rouleaux motorisés.
- Une cuve de zingage par plasma 11 permettant la galvanisation des substrats en acier après leur activation plasma dans la cuve d'activation 8.
- Une deuxième cuve de pompage 12 haut vide et de transport du substrat.
- Une seconde cuve de zingage par plasma 13 permettant la galvanisation des substrats en acier.

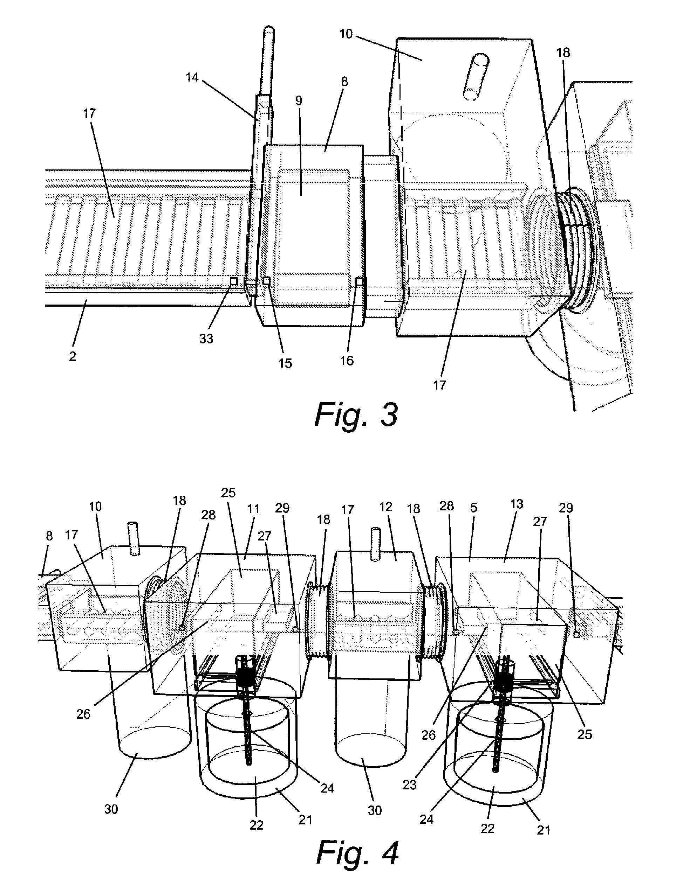

Le sas à vide d'entrée 2 est séparé de la cuve d'activation 8 par une porte étanche 14 isolant l'ensemble des zones de traitements 3, 4 et 5 de ce sas à vide 2, comme illustré en plus de détail dans la figure 3. Le substrat est introduit à partir de la zone d'introduction 1 via le sas à vide d'entrée 2, après ouverture de la porte étanche 14, dans la cuve d'activation 8 comprenant le dispositif d'activation par plasma 9. Le dispositif 9, initialement hors puissance, est activé dès que le substrat est détecté par un détecteur 15 qui est monté à l'endroit de l'entrée de la cuve d'activation 8. A la sortie de cette cuve d'activation, un deuxième détecteur 16 du substrat est prévu.

La puissance électrique appliquée au dispositif d'activation par plasma 9 est augmentée progressivement, proportionnellement à la longueur du substrat traversant l'espace entre les deux détecteurs 15 et 16 jusqu'à atteindre la puissance de fonctionnement nominale lorsque les deux détecteurs 15 et 16 sont activés par la présence du substrat dans la cuve d'activation 8. Dès que le détecteur d'entrée 15 n'est plus activé, la puissance fournie au dispositif d'activation 9 est diminuée proportionnellement à la longueur du substrat restant entre les deux détecteurs 15 et 16, jusqu'à coupure de la puissance électrique lorsque le substrat n'est plus ni détecté par le détecteur d'entrée 15, ni par le détecteur de sortie 16.

Dans cette configuration particulière de l'installation de galvanisation par plasma, le substrat est transporté sur des bancs de rouleaux motorisés 17 situé dans le sas à vide d'entrée 2 et dans les cuves de transport et de pompage haut-vide 10 et 12. Il est évident que d'autres moyens de transport, tel, par exemple, un monorail, traversant de part-en-part le sas à vide d'entrée 2, la cuve d'activation 8 et la cuve de transport et de pompage 10, permettant de suspendre les substrats à traiter et moyennant l'adaptation géométrique du dispositif d'activation 9 au passage des charges à traiter aurait permis d'assurer la même fonction que les tables à bancs de rouleaux motorisés 17 et que ce moyen de transport n'a aucune incidence sur la régulation du dispositif d'activation par plasma des substrats 9 via les détecteurs de d'entrée 15 et de sortie 16 du substrat en amont et en aval du dispositif d'activation par plasma 9 dans la cuve à vide 8.

Après que la surface du substrat ait été activée dans le dispositif d'activation 9, le substrat est dirigé sur la table à banc de rouleaux 17 dans la cuve de transport et de pompage 10 vers la première cuve de galvanisation par plasma 11 où il est en suspension libre, puis est à nouveau supporté et transporté par une table à banc de rouleaux 17 dans la cuve de transport et de pompage 12 avant de traverser en suspension libre la seconde cuve de galvanisation par plasma 13.

La connexion étanche et qualifiée pour le haut-vide entre les cuves de transport 10 et 12 et les cuves de galvanisation par plasma 11 et 13, permettant le passage du substrat à galvaniser d'une cuve à l'autre, est assurée au moyen d'un tube flexible 18. De préférence, ces connexions flexibles 18 sont solidaires de cuves de transport et de pompage 10 et 12 et serrées contre les brides usinées sur les cuves de galvanisation 11 et 13 par des vérins non représentés. Cette configuration particulière a pour avantage de permettre l'utilisation d'une cuve de galvanisation 11 et 13 constituée d'une table sur laquelle est disposée la partie supérieure de la cuve en forme de cloche, qui pouvant, en période d'entretien, être entièrement enlevée ou relevée, permettant ainsi un accès maximum à l'équipement disposé à l'intérieur de la cuve correspondante.

Les cuves de galvanisation 11 et 13 font partie d'un dispositif de galvanisation correspondant 19 et, respectivement, 20. Ces dispositifs de traitement de galvanisation 19 et 20 comprennent respectivement:
- une cuve à vide 21 contenant un four 22 de maintien à l'état fondu, et de régulation en température d'une réserve de zinc liquide permettant d'alimenter un creuset 23 situé dans la cuve de galvanisation correspondante 11 ou 13. La connexion entre les cuves à vide 21 et les cuves de galvanisation correspondantes 11 ou 13 est assurée exclusivement et respectivement au moyen d'un tube d'alimentation 24. Ce tube 24 est étanche aux gaz et doit permettre de maintenir une pression d'argon constante dans la cuve de galvanisation 11 ou 13 typiquement comprise entre 5.10⁻⁴ et 5.10⁻² mbar, alors que la pression de gaz d'argon ou d'azote dans la cuve à vide 21 contenant le four 22 peut typiquement varier entre 0.1 et 2000 mbar. Ceci est indispensable afin de permettre de vider ou d'alimenter le creuset 23 prévu dans la cuve de galvanisation correspondante 11 ou 13 en zinc liquide respectivement par diminution ou augmentation de la pression de gaz dans la cuve à vide 21 contenant le four 22.
- ladite cuve à vide de galvanisation 11 ou 13 contenant l'équipement de galvanisation par plasma constitué dudit creuset 23 surmonté d'une enceinte de confinement de la vapeur de zinc 25 confinant la vapeur de zinc au voisinage du substrat à galvaniser la traversant. Les parois de l'enceinte de confinement 25 sont généralement chauffées par des moyens classiques par effet Joule pour que le zinc ne puisse ni y condenser sous forme solide, ni sous forme liquide. En général la température intérieure des parois de l'enceinte de confinement 25 se situe entre 400 et 500°C. L'enceinte de confinement 25 présente une ouverture d'entrée 26 et une ouverture de sortie 27. Au voisinage de chaque ouverture 26 et 27 de l'enceinte de confinement 25, et à l'intérieur de la cuve de galvanisation 11 ou 13 respectivement, est prévu un détecteur de présence de substrat 28 et 29 permettant la régulation de la puissance électrique couplée au plasma servant à l'évaporation du zinc, lors du passage du substrat selon le schéma déjà exposé plus haut. Le creuset 23 conducteur électrique, généralement en graphite haute densité, est alimenté en zinc liquide par l'intermédiaire du tube 24 via une régulation de la pression de gaz dans la cuve à vide 21. Le creuset 23 est en moyenne polarisé négativement par rapport à une anode non représentée et située à l'intérieur de l'enceinte de confinement 25. Généralement, il est prévu un circuit magnétique situé en dessous du creuset 23 et permettant de réaliser une décharge magnétron dans la vapeur de zinc produite par dissipation de l'énergie du plasma à la surface du zinc liquide contenu dans le creuset 23. En cours de traitement d'un substrat, lorsque seul le détecteur d'entrée 28 du substrat est activé, la puissance électrique appliquée au plasma est augmentée progressivement, proportionnellement à la longueur du substrat traversant l'espace entre les deux détecteurs 28 et 29 jusqu'à atteindre la puissance de fonctionnement nominale lorsque les deux détecteurs 28 et 29 sont activés par la présence du substrat. Dès que le détecteur d'entrée du substrat 28 n'est plus activé mais que le détecteur de sortie 29 est encore activé, la puissance fournie au plasma servant à l'évaporation du zinc est diminuée proportionnellement à la longueur du substrat restant entre les deux détecteurs 28 et 29, jusqu'à coupure de la puissance électrique lorsque le substrat n'est plus détecté par l'un ou l'autre des détecteurs situés au voisinage des ouvertures d'entrée et de sortie du substrat de l'enceinte de confinement 25. La qualification de détecteur d'entrée 28, en amont de l'enceinte 25, ou de détecteur de sortie 29, en aval de l'enceinte 25, dépend uniquement de la position du détecteur par rapport au sens d'avancement du substrat. Il en résulte que si les détecteurs 28 et 29 ont un caractère d'entrée ou de sortie absolu dans une installation fonctionnant dans un seul sens, ce n'est pas le cas d'une installation ne disposant que d'un seul sas et fonctionnant donc d'abord dans un sens puis dans l'autre. Dans ce cas, un détecteur d'entrée dans un sens d'avance du substrat devient un détecteur de sortie dans le sens opposé et réciproquement.

Lorsque le substrat est constitué d'une tôle, les détecteurs d'entrée 15 et 28 et les détecteurs de sortie 16 et 29 peuvent mesurer également la largeur de la tôle afin de déterminer, par exemple, l'aire de la tôle qui est présent dans la zone de traitement concernée.

### 4. Conditions opérationnelles et configurations particulières de l'invention

### a) Gestion de la pression des gaz en cours de traitement

Un programme maître contrôle les ouvertures et fermetures des portes étanches 14, ainsi que l'enclenchement et le déclenchement des pompes à vide 30 connectées aux cuves à vide respectives, afin de maintenir une pression de gaz constante dans les zones de traitement 3, 4 et 5 de l'installation en isolant ces zones par des portes étanches 14 des sas d'entrée 2 et de sortie 6 lorsque ces sas 2 et 6 ne sont pas à une pression inférieure à la pression d'argon régnant dans les zones de traitement 3, 4 et 5. Généralement, de l'argon est présent dans ces zones à une pression entre 0.05 et 5 Pa, de préférence de l'ordre de 0.5 Pa.

### b) Système d'avance en production

Le système d'avance est caractérisé par l'existence de deux gammes de vitesse différentes, une vitesse de transport qui est une vitesse d'avance rapide pour les entrées et sortie des sas à vide 2 et 6 et une vitesse de traitement qui est plus lente pour la galvanisation. Ceci est essentiel pour assurer une productivité suffisante en limitant les temps d'entrée et de sortie des substrats du ou des sas à vide. La vitesse de transport est supérieure à la vitesse de traitement pour limiter les transitoires. Généralement, la vitesse de traitement est inférieure à 30 m/min et la vitesse de transport est supérieure à 20 m/min.

L'avance des substrats est contrôlée par des détecteurs de présence des substrats situés sur le chemin parcouru par les substrats durant un cycle complet de traitement et gérée par le programme maître. Il y a au moins un détecteur de présence de substrat en amont et en aval de chaque porte étanche 14 au vide permettant le passage du substrat, et au moins un détecteur de présence de substrat en amont 15, respectivement 28, et en aval 16, respectivement 29, de chaque équipement de traitement des zones 3, 4 et 5. Le contrôle des signaux transmis par les détecteurs amont et aval par rapport à une porte étanche 14 ou à un équipement de traitement permettent de déterminer le début et la fin du passage d'un substrat.

L'avance des substrats contrôlée par le programme maître est subordonnée à l'ouverture des portes étanches d'isolation 14 entre les sas d'entrée 2 et de sortie 6 et les zones de traitement 3, 4 et 5, elle-même subordonnée à une mesure de la pression de gaz régnant dans ces zones de traitement 3, 4 et 5 de l'installation.

### c) Asservissement des équipements de traitement

Chaque équipement de traitement est asservi à l'avance du substrat par la détection du substrat par au moins un détecteur de présence du substrat situé en amont 15, respectivement 28, et au moins un détecteur de présence du substrat situé en aval 16, respectivement 29, des dispositifs de traitement par plasma.

### d) Gestion des équipements de traitement

Chaque dispositif de traitement 9, 19 et 20 est géré par un programme esclave spécifique à ce dispositif de traitement contrôlant son enclenchement, la montée, le maintien, et la diminution de la puissance électrique couplée au plasma fournie pour le traitement et finalement son déclenchement en fonction des signaux transmis par les détecteurs situés en amont et en aval dudit dispositif. La puissance couplée au plasma augmente proportionnellement à l'aire du substrat situé entre les détecteurs d'entrée, en amont, et de sortie, en aval, lorsque seul le détecteur d'entrée 15 ou, respectivement 28, est activé. La puissance couplée au plasma est nominale lorsque les deux détecteurs 15 et 16 ou, respectivement, 28 et 29 sont activés par le substrat. La puissance couplée au plasma diminue proportionnellement à l'aire du substrat situé entre les deux détecteurs lorsque seul le détecteur de sortie 16, respectivement 29, en aval par rapport à l'avance du substrat est activé. Les détecteurs de présence du substrat peuvent fonctionner suivant un principe quelconque, qu'il soit mécanique, magnétique, électrique ou optique.

### c) Fonctions spécifiques du programme esclave de gestion d'une unité de galvanisation par plasma

Faisant référence à la figure 4 et considérant le dispositif de galvanisation par plasma 19 ou 20, le programme esclave de gestion d'un dispositif de galvanisation par plasma 19 ou 20 comprend les fonctions suivantes :
- le contrôle par un moyen quelconque, comme par exemple par pesée, par contact électrique ou par mesure optique, et le maintient du niveau de zinc liquide dans le creuset 23 via le tube d'alimentation 24 débouchant dans le fond du creuset 23, en agissant sur la pression de gaz dans la cuve à vide 21 contenant le four 22 hébergeant une réserve de zinc liquide;
- le maintien à température constante minimale, qui est typiquement entre 400 et 500°C, des parois intérieures de l'enceinte de confinement 25 afin d'y éviter toute condensation en zinc sous forme liquide ou solide ;
- le contrôle de la puissance couplée au plasma formé dans la vapeur de zinc via l'alimentation électrique connectée au creuset 23 assuré par les détecteurs d'entrée 28 et de sortie 29 de la manière suivante :
   o tant que les détecteurs d'entrée 28 et de sortie 29 ne sont pas activés l'alimentation électrique ne délivre aucune puissance pour générer le plasma dans l'enceinte de confinement 25 ou, délivre, plus généralement, une puissance minimale;
   o lorsque le détecteur d'entrée 28 est activé par la présence du substrat, la puissance couplée au plasma et fournie par l'alimentation électrique est montée proportionnellement à l'aire du substrat contenu dans l'enceinte de confinement 25, pour atteindre une puissance nominale constante délivrée par l'alimentation lorsque le détecteur d'entrée 28 et le détecteur de sortie 29 correspondant sont activés ;
   o lorsque le détecteur d'entrée cesse d'être activé par le substrat, la puissance couplée au plasma est diminuée progressivement proportionnellement à l'aire du substrat contenu dans l'enceinte de confinement 25 ;
   o lorsque les détecteurs d'entrée 28 et de sortie 29 sont tous les deux inactifs, l'alimentation ne délivre plus aucune puissance ou, délivre, plus généralement, une puissance minimale.

Dans le cas où le substrat se déplacerait du deuxième dispositif de galvanisation 20 vers le premier dispositif à galvanisation 19, le processus serait inversé par rapport aux deux détecteurs 28 et 29 puisque, dans ce cas, le détecteur d'entrée 28 deviendrait le détecteur de sortie et le détecteur de sortie 29 deviendrait le détecteur d'entrée par rapport à au dispositif de galvanisation par plasma.

### 5. Exemple d'application pratique.

Une installation telle que représentée aux figures 1 à 4 permet le zingage par plasma de substrats longs en acier. Cette installation comprend une table de chargement des substrats 31 dans la zone d'introduction 1, un sas à vide d'entrée 2, des zones de traitement 3, 4 et 5 des substrats toujours maintenue sous 0.005 mbar d'argon, un sas à vide de sortie 6, et une table de déchargement des substrats 32 dans la zone de sortie 7.

Les zones de traitement située entre les deux sas à vide d'entrée 2 et de sortie 6 des substrats dans et de l'installation, comprend une zone de traitement 3 pour l'activation de la surface des substrats en acier par bombardement d'ions permettant l'élimination de tout oxyde ou contamination superficielle afin de permettre une bonne adhérence du dépôt de zinc. Cette zone de traitement 3 est suivie d'une cuve de transport et de pompage haut-vide 10 munie d'une pompe à diffusion 30, d'une première cuve de galvanisation par plasma 11, une seconde cuve de transport et de pompage 12, et finalement une seconde cuve de galvanisation par plasma 13. Cette dernière est en correspondance avec le sas à vide de sortie 6 à travers une porte étanche 14. Les zones de traitement sont en particulier isolées des sas à vide d'entrée 2 et de sortie 6 par des portes étanches 14 lorsque la pression résiduelle d'air régnant dans les sas à vide 2 ou 6 est supérieure à 10⁻⁴ mbar. Le système de transport est constitué de bancs de rouleaux motorisés 17, et les substrats sont transportés à travers l'installation de la zone d'introduction 1 vers la zone de sortie 7.

L'installation est conçue pour traiter des substrats longs tels que des barres à béton et des poutrelles de 12 m de long au maximum déposées en vrac sur la table de chargement 1. Ainsi le substrat est constitué de plusieurs produits s'étendant l'un à côté de l'autre. Le poids d'acier qui peut être galvanisé par batch est typiquement compris entre 500 kg et 1300 kg en fonction de la géométrie des substrats traités et de l'épaisseur de la couche de zinc visée.

La séquence de traitement comprend les étapes suivantes :
- Chargement du substrat sur la table de chargement 31 ;
- Isolation des zones de traitement 3, 4 et 5 du sas à vide d'entrée 2 par fermeture de la porte étanche 14 ;
- Remise à l'air du sas à vide d'entrée 2 ;
- Ouverture de la porte étanche extérieure 14 du sas d'entrée 2 adjacente à la zone d'entrée 1 ;
- Introduction des substrats à la vitesse de transport de 60 m/min jusqu'au fond du sas à vide d'entrée 2, arrêt du banc de rouleau 17 par détection de la tête de charge au fond du sas d'entrée 2 via un détecteur 33 de présence de charge ;
- Fermeture de la porte étanche extérieure 14 du sas à vide d'entrée 2 ;
- Mise sous haut vide du sas à vide d'entrée 2 ;
- Ouverture de la porte étanche 14 intermédiaire entre le sas à vide d'entrée 2 et la première zone de traitement 3 ;
- Avance de la charge à traiter à sa vitesse de traitement de 9 m/min ;
- Traitement d'activation plasma de la surface dans la première zone de traitement 3 activé par les détecteurs d'entrée 15 et de sortie 16 ;
- Traitement de galvanisation par évaporation plasma dans le dispositif de galvanisation 19 activé par les détecteurs d'entrée 28 et de sortie 29 ;
- Traitement de galvanisation par évaporation plasma dans le deuxième dispositif de galvanisation 20 activé par les détecteurs d'entrée 28 et de sortie 29 correspondants ;
- Lorsque le substrat est détecté au fond du sas à vide de sortie 6, la porte étanche 14 entre le deuxième dispositif de galvanisation 20 et ce sas à vide de sortie 6 est refermée ;
- Remise à l'air du sas à vide de sortie 6 ;
- Lorsque la pression atmosphérique est atteinte dans le sas à vide de sortie 6, la porte étanche extérieure de ce sas 6 s'ouvre ;
- Sortie du substrat du sas à vide de sortie 6 à la vitesse de transport de 60 m/min jusqu'à sa détection à l'extrémité de la table de déchargement 32 dans la zone de déchargement 7 ;
- Déchargement du substrat de la table de déchargement 32 ;
- Fermeture de la porte étanche extérieure 14 du sas à vide de sortie 6 ;
- Mise sous haut vide du sas à vide de sortie 6 ;
- Ouverture de la porte étanche intérieure 14 entre le sas à vide de sortie 6 et le deuxième dispositif à galvanisation 20.

A une vitesse de transport de 60 m/min le temps d'introduction du substrat à traiter dans le sas à vide d'entrée 2, ou le temps de sortie vers la table de déchargement 32 du substrat, du sas à vide de sortie 6, est de l'ordre de 12 secondes seulement, alors que le temps de libération du sas à vide d'entrée 2 à la vitesse de traitement de 9 m/s est de l'ordre de 80 secondes. Dans cette installation, le temps pour un nouveau cycle dans le sas à vide d'entrée 2 est de 4 min, contre 3,41 min pour un nouveau cycle dans le sas à vide de sortie 6. C'est donc le temps le plus long, correspondant au temps du cycle de fonctionnement du sas à vide d'entrée 2, qui limite la productivité de cette installation à environ 19 tonnes par heure.

Cet exemple pratique montre l'intérêt de travailler avec une vitesse de transport la plus élevée possible pour diminuer les temps d'attente et augmenter la productivité de l'installation.

La table de chargement 31 peut être chargée dès que libérée. Lorsqu'aucune charge n'est détectée dans le sas à vide d'entrée 2 celui-ci est isolé et remis à pression atmosphérique. Le même principe étant appliqué pour le sas à vide de sortie 6, et des détecteurs d'entrée et de sortie en amont et en aval de chaque unité de traitement permettant via un programme esclave la gestion de la puissance électrique nécessaire au procédé, le système peut fonctionner entre sa production maximale déterminée par le temps de libération du sas à vide d'entrée 2 et une production moindre limitée par le chargement de la table 31 sans nécessiter une gestion centralisée de l'ensemble des déplacements et des procédés de l'installation du fait que la gestion des procédés soit subordonnée à la détection des substrats en amont et en aval des divers dispositifs de traitement de l'installation.

Le programme maître, une fois l'installation prête pour la production, lorsque la pression nominale d'argon de 0,005 mbar est atteinte dans les zones de traitement 3, 4 et 5 et lorsque les creusets 23 des deux unités de galvanisation par plasma 19 et 20 sont alimentés en zinc liquide, gère le passage des substrats à traiter de la table de chargement 31 vers la table de déchargement 32 le plus rapidement possible en assurant les séquences de mise sous vide et de remise à l'air des sas à vide d'entrée 2 et de sortie 6 ainsi que le transport des substrats du sas à vide d'entrée 2 vers la cuve d'activation 8 et du dispositif de galvanisation 20 vers le sas à vide de sortie 6 et entre les zone de traitement 3, 4 et 5 aux vitesses de transport de 60 m /min et de traitement de 9 m / min, respectivement.

La zone d'activation 3 comprend un dispositif d'activation par plasma du substrat qui est constitué d'une source de plasma inductive, alimentée par un générateur radiofréquence (RF), et d'une anode lui faisant face, permettant d'accélérer les ions d'argon produits par la source inductive vers la surface du substrat, au moyen d'un générateur en courant continu (DC). Le dispositif d'activation par plasma est géré au passage du substrat par les détecteurs d'entrée 15 et de sortie 16 via la séquence logique suivante lorsqu'une pression de 5.10⁻³ mbar en argon est atteinte dans la cuve d'activation 8 :
IF ("détecteur 15" = ON AND "détecteur 16" = OFF) THEN
   RF power ON
   DC power ramp up
ELSE IF ("détecteur 15" = ON AND "détecteur 16" = ON) THEN
   RF power ON
   DC power to nominal value
ELSE IF ("détecteur 15" = OFF AND "détecteur 16" = ON) THEN
   RF power ON
   DC power ramp down
ELSE IF ("détecteur 15" = OFF AND "détecteur 16" = OFF) THEN
   DC power OFF
   RF power OFF
Lorsqu'une pression d'argon de 5.10⁻³ mbar est atteinte dans la cuve de galvanisation 11 de la zone de galvanisation 4, que les parois internes de l'enceinte de confinement 25 sont à 500°C, et que de plus le creuset 23 est alimenté en zinc liquide, le dispositif de zingage par plasma 19 est géré au passage du substrat par les détecteurs d'entrée 28 et de sortie 29 via la séquence logique suivante :
   IF ("détecteur 28" = ON AND "détecteur 29" = OFF) THEN
      "creuset 23" Zn level control
      Plasma power ramp up
   ELSE IF ("détecteur 28" = ON AND "détecteur 29"= ON) THEN
      "creuset 23" Zn level control
      Plasma power to nominal value
   ELSE IF ("détecteur 28" = OFF AND "détecteur 29" = ON) THEN
      "creuset 23" Zn level control
      Plasma power ramp down
   ELSE IF ("détecteur 28" = OFF AND "détecteur 29" = OFF) THEN
      Plasma power to minimal value

Il faut noter que « minimal value » peut dans certains cas signifier la coupure pure et simple de l'alimentation électrique. Tout dépend de la puissance nécessaire au maintien en température du zinc liquide contenu dans le creuset 23 pour éviter qu'il ne se solidifie. En général, la puissance rayonnée par les parois chaudes de l'enceinte de confinement 25 suffit et dans ce cas l'alimentation électrique peut être coupée (Plasma power OFF).

## Revendications

1. Procédé de traitement par plasma de substrats successifs comprenant un ou plusieurs produits en acier dans lequel l'on transporte les substrats l'un après l'autre à travers au moins une zone de traitement par plasma (3,4,5), **caractérisé en ce que** l'on fait varier la puissance électrique fournie pour générer le plasma dans la zone de traitement (3,4,5) en fonction de l'aire du substrat présent dans cette zone de traitement (3,4,5) lorsque le substrat défile à travers cette zone (3,4,5).

2. Procédé suivant la revendication 1, **caractérisé en ce qu'**un plasma est généré dans la zone de traitement (3,4,5) lorsque le substrat entre dans cette zone et est désactivé lorsque ce produit a quitté la zone de traitement (3,4,5).

3. Procédé suivant la revendication 1 ou 2, **caractérisé en ce que** la puissance électrique générant un plasma dans la zone de traitement (3,4,5) est augmentée proportionnellement à l'aire du substrat entrant la zone de traitement (3.4.5) jusqu'à ce qu'une puissance nominale de fonctionnement soit atteinte lorsque le substrat s'étend selon toute la longueur de la zone de traitement (3,4,5) suivant la direction de défilement du substrat.

4. Procédé suivant l'une quelconque des revendications 1 à 3, **caractérisé en ce que** la puissance électrique générant le plasma est diminuée proportionnellement à l'aire du substrat présent dans la zone de traitement (3,4,5) lorsque ce produit sort de cette zone jusqu'à ce qu'une puissance minimale de fonctionnement soit atteinte ou jusqu'à ce que l'alimentation électrique du plasma généré soit coupée au moment où le substrat est sorti entièrement de la zone de traitement (3,4,5).

5. Procédé suivant l'une quelconque des revendication 1 à 4, **caractérisé en ce que** l'entrée d'un substrat dans la zone de traitement (3,4,5) et la sortie de ce substrat de cette zone de traitement (3,4,5) est détectée et **en ce que** la puissance électrique générant le plasma est contrôlée sur base de cette détection du substrat en fonction de l'aire du substrat présent dans la zone de traitement (3,4,5).

6. Procédé suivant la revendication 5, **caractérisé en ce que** le traitement des substrats dans les zones de traitement (3,4,5) est commandé indépendamment par un programme esclave sur base des signaux générés par la détection de l'entrée du substrat dans la zone de traitement (3,4,5) et par la détection de la sortie du substrat de cette zone de traitement (3,4,5), ce programme esclave étant subordonné à un signal émis par un programme maître lorsque les conditions physiques requises préalablement à la création d'un plasma dans la zone de traitement (3,4,5) sont atteintes.

7. Procédé suivant l'une quelconque des revendications 1 à 6, **caractérisé en ce que** les substrats sont transportés à travers une première zone de traitement (3) dans laquelle la surface des substrats est activée par bombardement d'ions, suivi par au moins une deuxième zone de traitement (4,5) dans laquelle les substrats sont revêtus par condensation de zinc évaporé par plasma sur la surface des substrats.

8. Procédé suivant la revendication 7, **caractérisé en ce que**, dans la deuxième zone de traitement (4,5), une puissance électrique est délivrée au plasma et dissipée, par bombardement d'ions issus du plasma à la surface de zinc liquide présent dans cette deuxième zone de traitement (4,5), en fonction de l'aire du substrat présent dans cette zone lors du défilement de ce substrat.

9. Procédé suivant l'une quelconque des revendications 1 à 8, **caractérisé en ce que** les substrats sont transportés vers la zone de traitement (3,4,5) et de cette zone à travers un sas à vide d'entrée (2) et un sas à vide de sortie (6).

10. Procédé suivant la revendication 9, **caractérisé en ce que** les substrats sont introduits dans le sas à vide d'entrée (2) et sortent du sas à vide de sortie (6) à une vitesse de transport qui est déterminée en fonction d'une vitesse de traitement des substrats dans la zone de traitement (3,4,5) et qui est supérieure à cette vitesse de traitement.

11. Installation de traitement par plasma de substrats successifs comprenant un ou plusieurs produits en acier, cette installation présentant au moins un dispositif de traitement par plasma (9,19,20) avec une enceinte dans laquelle une zone de traitement est prévue et des moyens de transport (17) pour faire défiler les substrats à travers la zone de traitement du dispositif (9,19,20), **caractérisée en ce qu'**un détecteur (15,16,28,29) est prévu à l'entrée et à la sortie du dispositif de traitement(9,19,20), ces détecteurs (15,16,28,29) coopérant par l'intermédiaire d'un programme esclave avec une alimentation en puissance électrique fournie pour générer un plasma dans la zone de traitement en fonction de l'aire du substrat présent dans cette zone de traitement lorsque le substrat défile à travers cette zone.

12. Installation suivant la revendication 11, **caractérisée en ce qu'**elle comprend un premier dispositif de traitement (9) présentant une cuve à vide (8) avec une source à ions par plasma permettant d'activer la surface des substrats, suivi d'au moins un deuxième dispositif de traitement (19,20) présentant une cuve à vide de zingage (11,13) permettant la galvanisation des substrats.

13. Installation suivant la revendication 12, **caractérisée en ce qu'**un sas à vide d'entrée (2) est prévu en amont du premier dispositif (9) qui est séparé de la cuve (8) du premier dispositif (9) par une porte étanche (14), un détecteur de l'entrée (15) du substrat étant prévu dans la cuve (8) en amont de la zone de traitement du premier dispositif (9) et un détecteur de sortie (16) du substrat étant monté dans la cuve (8) en aval de cette zone de traitement.

14. Installation suivant la revendication 13, **caractérisée en ce que** le sas à vide d'entrée (2) comprend un détecteur (33) permettant de détecter l'arrivé d'un substrat en regard de ladite porte étanche (14).

15. Installation suivant l'une quelconque des revendications 12 à 14, **caractérisée en ce que** la cuve à vide de zingage (10,13) du deuxième dispositif (19,20) comprend une enceinte de confinement (25) de la vapeur de zinc dans lequel un creuset (23) contenant du zinc liquide est présent et des moyens pour générer un plasma dans la zone de traitement à l'intérieur de cette enceinte (25) permettant de former de la vapeur de zinc par une dissipation de l'énergie du plasma à la surface du zinc liquide contenu dans le creuset (23), un détecteur de l'entrée du substrat (28) étant prévu dans la cuve à vide de zingage (11,13) en amont de l'enceinte de confinement (25) et un détecteur de sortie du substrat (29) étant monté dans cette cuve (11,13) en aval de l'enceinte (25).

16. Installation suivant la revendication 15, **caractérisée en ce que** ledit creuset (23) est alimenté en zinc liquide par l'intermédiaire d'un tube (24) à partir d'un four (22) situé dans une cuve à vide (21) séparée de la cuve à vide de zingage (11,13), le four (22) contenant du zinc qui est maintenu au moins partiellement à l'état fondu et dans lequel une extrémité dudit tube (24) est immergée.

17. Installation suivant l'une quelconque des revendications 12 à 16, **caractérisée en ce que** la cuve à vide de zingage (11,13) est suivie d'un sas à vide de sortie (6) qui est séparé de la cuve de zingage (11,13) par une porte étanche (14).

18. Installation suivant la revendication 17, **caractérisée en ce que** le sas à vide de sortie (6) comprend un détecteur permettant de détecter le passage complet du substrat à travers ladite porte étanche (14) du deuxième dispositif (19,20).

19. Installation suivant l'une quelconque des revendications 12 à 18, **caractérisée en ce qu'**une cuve de transport (10,12) est prévue entre le premier (9) et le deuxième dispositif (19,20) présentant des moyens pour faire défiler les substrats à travers les zones de traitement du premier et du deuxième dispositif.

20. Installation suivant l'une quelconque des revendications 12 à 19, **caractérisée en ce que** la cuve à vide de zingage (11,13) est précédée ou suivie par une cuve de transport (10,12) présentant des moyens d'entrainement (17) pour faire défiler les substrats à travers la cuve à vide de zingage (11,13).

21. Installation suivant l'une quelconque des revendications 12 à 20, **caractérisée en ce que** lesdites cuves (8,10,11,12,13) comprennent une table sur laquelle est disposée une partie supérieure de la cuve concernée en forme de cloche, pouvant être entièrement enlevée ou relevée afin de permettre un accès l'équipement disposé à l'intérieur de la cuve.

22. Installation suivant l'une quelconque des revendications 12 à 21, **caractérisée en ce que** la cuve à vide de zingage (11,13) est connectée à une ou à plusieurs cuves adjacentes (10,12) par une connexion flexible et étanche en forme de tube (18) permettant le passage des substrats à travers cette connexion entre les cuves successives.

23. Installation suivant l'une quelconque des revendications 11 à 22, **caractérisée en ce qu'**elle comprend un programme maître qui contrôle le défilement des substrats en fonction de la présence des conditions physiques requises préalablement à la création d'un plasma dans le dispositif de traitement par plasma (9,19,20), un programme esclave étant associé à chaque dispositif de traitement par plasma et subordonné au programme maître, ce programme esclave coopérant avec les détecteurs d'entrée (15,28) et de sortie (16,29) afin de réguler la puissance électrique générant le plasma en fonction du signal des détecteurs d'entrée (15,28) et de sortie (16,29) de sorte que la puissance couplée au plasma augmente proportionnellement à l'aire du substrat lorsque le détecteur d'entrée (15,28) détecte un substrat et aucun substrat n'est détecté par le détecteur de sortie (16,29) et que cette puissance est nominale lorsque le détecteur d'entrée (15,28) et le détecteur de sortie (16,29) détectent ce substrat et que cette puissance est diminuée proportionnellement à l'aire du substrat située entre les détecteurs d'entrée (15,28) et de sortie (16,29) lorsque seulement le détecteur de sortie détecte (16,29) la présence du substrat.

## Claims

1. Method for the plasma treatment of successive substrates comprising one or more steel products, in which the substrates are transported one after the other through at least one plasma treatment zone (3,4,5), **characterised in that** the electrical power supplied to generate the plasma in the treatment zone (3,4,5) is varied according to the area of the substrate present in this treatment zone (3,4,5) when the substrate is passing through this zone (3,4,5).

2. Method according to claim 1, **characterised in that** a plasma is generated in the treatment zone (3,4,5) when the substrate enters this zone and is deactivated when this product has left the treatment zone (3,4,5).

3. Method according to claim 1 or 2, **characterised in that** the electrical power generating a plasma in the treatment zone (3,4,5) is increased proportionally to the area of the substrate entering the treatment zone (3,4,5) until a nominal operating power is reached when the substrate extends along the entire length of the treatment zone (3,4,5) in the direction of travel of the substrate.

4. Method according to any one of claims 1 to 3, **characterised in that** the electrical power generating the plasma is reduced proportionally to the area of the substrate present in the treatment zone (3,4,5) when this product leaves this zone until a minimal operating power is reached or until the electrical supply to the plasma generated is cut when the substrate has completely left the treatment zone (3,4,5).

5. Method according to any one of claims 1 to 4, **characterised in that** the entry of a substrate in the treatment zone (3,4,5) and the exit of this substrate from the treatment zone (3,4,5) is detected and **in that** the electrical power generating the plasma is controlled on the basis of this detection of the substrate according to the area of the substrate present in the treatment zone (3,4,5).

6. Method according to claim 5, **characterised in that** the treatment of the substrates in the treatment zones (3,4,5) is controlled independently by a slave program on the basis of the signals generated by the detection of the entry of the substrate in the treatment zone (3,4,5) and by the detection of the exit of the substrate from this treatment zone (3,4,5), this slave program being dependent on a signal sent by a master program when the physical conditions required prior to the creation of a plasma in the treatment zone (3,4,5) are achieved.

7. Method according to any one of claims 1 to 6, **characterised in that** the substrates are transported through a first treatment zone (3) in which the surface of the substrates is activated by ion bombardment, followed by at least a second treatment zone (4,5) in which the substrates are coated by zinc condensation evaporated by plasma on the surface of the substrates.

8. Method according to claim 7, **characterised in that**, in the second treatment zone (4,5), electrical power is delivered to the plasma and dissipated, by bombardment of ions issuing from the plasma on the surface of the liquid zinc present in this second treatment zone (4,5), according to the area of the substrate present in this zone when this substrate passes.

9. Method according to any one of claims 1 to 8, **characterised in that** the substrates are transported to the treatment zone (3,4,5) and from this zone through an entry vacuum airlock (2) and an exit vacuum airlock (6).

10. Method according to claim 9, **characterised in that** the substrates are introduced into the entry vacuum airlock (2) and leave the exit vacuum airlock (6) at a transport speed that is determined according to a speed of treatment of the substrates in the treatment zone (3,4,5) and is greater than this treatment speed.

11. Plant for the plasma treatment of successive substrates comprising one or more steel products, this plant having at least one plasma treatment device (9,19,20) with a chamber in which a treatment zone is provided and transport means (17) for passing the substrates through the treatment zone of the device (9,19,20), **characterised in that** a detector (15,16,28,29) is provided at the entry and exit of the treatment device (9,19,20), these detectors (15,16,28,29) cooperating by means of a slave program with an electrical power supply provided in order to generate a plasma in the treatment zone according to the area of the substrate present in this treatment zone when the substrate passes through this zone.

12. Plant according to claim 11, **characterised in that** it comprises a first treatment device (9) having a vacuum vessel (8) with a plasma ion source for activating the surface of the substrates, followed by at least a second treatment device (19,20) having a zinc plating vacuum vessel (11,13) for galvanising the substrates.

13. Plant according to claim 12, **characterised in that** an entry vacuum airlock (2) is provided upstream of the first device (9) that is separated from the vessel (8) of the first device (9) by an airtight door (14), a detector (15) for the entry of the substrate being provided in the vessel (8) upstream of the treatment zone of the first device (9) and a detector (16) for the exiting of the substrate being mounted in the vessel (8) downstream of this treatment zone.

14. Installation according to claim 13, **characterised in that** the entry vacuum airlock (2) comprises a detector (33) for detecting the arrival of a substrate opposite said airtight door (14).

15. Plant according to any one of claims 12 to 14, **characterised in that** the zinc plating vacuum vessel (10,13) of the second device (19,20) comprises a confinement chamber (25) for the zinc vapour in which a crucible (23) containing liquid zinc is present and means for generating a plasma in the treatment zone within this chamber (25) making it possible to form zinc vapour by dissipation of the energy of the plasma on the surface of the liquid zinc contained in the crucible (23), a detector for the entry of the substrate (28) being provided in the zinc plating vacuum vessel (11,13) upstream of the confinement chamber (25) and a detector (29) for the exiting of the substrate being mounted in this vessel (11,13) downstream of the chamber (25).

16. Plant according to claim 15, **characterised in that** said crucible (23) is supplied with liquid zinc by means of a tube (24) from a furnace (22) situated in a vacuum vessel (21) separate from the zinc plating vacuum vessel (11,13), the furnace (22) containing zinc that is maintained at least partially in the molten state and in which an end of said tube (24) is immersed.

17. Plant according to any one of claims 12 to 16, **characterised in that** the zinc plating vacuum vessel (11,13) is followed by an exit vacuum airlock (6) that is separated from the zinc-plating vessel (11,13) by an airtight door (14).

18. Plant according to claim 17, **characterised in that** the exit vacuum airlock (6) comprises a detector for detecting the complete passage of the substrate through said airtight door (14) of the second device (19,20).

19. Plant according to any one of claims 12 to 18, **characterised in that** a transport vessel (10,12) is provided between the first device (9) and the second device (19,20) having means for moving the substrates through the treatment zones of the first and second devices.

20. Plant according to any one of claims 12 to 19, **characterised in that** the zinc plating vacuum vessel (11,13) is preceded or followed by a transport vessel (10,12) having driving means (17) for passing the substrates through the zinc plating vacuum vessel (11,13).

21. Plant according to any one of claims 12 to 20, **characterised in that** the said vessels (8,10,11,12,13) comprise a table on which a bell-shaped top part of the vessel concerned is disposed, able to be entirely removed or raised in order to allow access to the equipment disposed inside the vessel.

22. Plant according to any one of claims 12 to 21, **characterised in that** the zinc plating vacuum vessel (11,13) is connected to one or more adjacent vessels (10,12) by a flexible airtight connection in the form of a tube (18) enabling the substrates to pass through this connection between the successive vessels.

23. Plant according to any one of claims 11 to 22, **characterised in that** it comprises a master program that controls the passage of the substrates according to the presence of the physical conditions required prior to the creation of a plasma in the plasma treatment device (9,19,20), a slave program being associated with each plasma treatment device and dependent on the master program, this slave program cooperating with the entry (15,28) and exit (16,29) detectors in order to regulate the electrical power generating the plasma according to the signal from the entry (15,28) and exit (16,29) detectors so that the power coupled to the plasma increases proportionally to the area of the substrate when the entry detector (15,28) detects a substrate and no substrate is detected by the exit detector (16, 29) and **in that** this power is nominal when the entry detector (15,28) and the exit detector (16,29) detect this substrate and **in that** this power is reduced proportionally to the area of the substrate situated between the entry (15,28) and exit (16,29) detectors when only the exit detector (16,29) detects the presence of the substrate.

## Patentansprüche

1. Verfahren zur Plasmabehandlung von aufeinanderfolgenden Substraten, umfassend ein oder mehrere Erzeugnisse aus Stahl, wobei die Substrate nacheinander durch mindestens einen Plasmabehandlungsbereich (3, 4, 5), befördert werden, **dadurch gekennzeichnet, dass** die elektrische Energie, die zur Erzeugung des Plasmas in dem Behandlungsbereich (3, 4, 5) bereitgestellt wird, in Abhängigkeit von der in diesem Behandlungsbereich (3, 4, 5) befindlichen Fläche des Substrats variiert wird, wenn das Substrat durch diesen Bereich (3, 4, 5) läuft.

2. Verfahren nach Anspruch 1, **dadurch gekennzeichnet, dass** ein Plasma im Behandlungsbereich (3, 4, 5) erzeugt wird, wenn das Substrat in diesen Bereich eintritt, und deaktiviert wird, wenn dieses Erzeugnis den Behandlungsbereich (3, 4, 5) verlassen hat.

3. Verfahren nach Anspruch 1 oder 2, **dadurch gekennzeichnet, dass** die elektrische Energie, die ein Plasma im Behandlungsbereich (3, 4, 5) erzeugt, proportional zu der in den Behandlungsbereich (3, 4, 5) eintretenden Fläche des Substrats erhöht wird, bis eine Nennbetriebsleistung erreicht ist, wenn sich das Substrat über die gesamte Länge des Behandlungsbereichs (3, 4, 5) in Laufrichtung des Substrats erstreckt.

4. Verfahren nach einem der Ansprüche 1 bis 3, **dadurch gekennzeichnet, dass** die elektrische Energie, die das Plasma erzeugt, proportional zu der im Behandlungsbereich (3, 4, 5) befindlichen Fläche des Substrats verringert wird, wenn dieses Erzeugnis aus diesem Bereich austritt, bis eine Mindestbetriebsleistung erreicht ist oder bis die Stromversorgung des erzeugten Plasmas in dem Moment unterbrochen wird, in dem das Substrat zur Gänze aus dem Behandlungsbereich (3, 4, 5) ausgetreten ist.

5. Verfahren nach einem der Ansprüche 1 bis 4, **dadurch gekennzeichnet, dass** der Eintritt eines Substrats in den Behandlungsbereich (3, 4, 5) und der Austritt dieses Substrats aus diesem Behandlungsbereich (3, 4, 5) erkannt wird und dass die elektrische Energie, die das Plasma erzeugt, auf der Grundlage dieser Erkennung des Substrats in Abhängigkeit von der im Behandlungsbereich (3, 4, 5) befindlichen Fläche des Substrats geregelt wird.

6. Verfahren nach Anspruch 5, **dadurch gekennzeichnet, dass** die Behandlung der Substrate in den Behandlungsbereichen (3, 4, 5) auf unabhängige Weise von einem Slave-Programm auf der Grundlage der Signale gesteuert wird, die durch die Erkennung des Eintritts des Substrats in den Behandlungsbereich (3, 4, 5) und durch die Erkennung des Austritts des Substrats aus diesem Behandlungsbereich (3, 4, 5) erzeugt werden, wobei dieses Slave-Programm einem Signal untergeordnet ist, das von einem Master-Programm ausgesendet wird, wenn die physikalischen Bedingungen erreicht sind, die vor der Erzeugung eines Plasmas im Behandlungsbereich (3, 4, 5) notwendig sind.

7. Verfahren nach einem der Ansprüche 1 bis 6, **dadurch gekennzeichnet, dass** die Substrate durch einen ersten Behandlungsbereich (3) befördert werden, in dem die Oberfläche der Substrate durch Ionenbeschuss aktiviert wird, und danach durch mindestens einen zweiten Behandlungsbereich (4, 5), in dem die Substrate durch eine Kondensation von Zink beschichtet werden, das mittels Plasma auf die Oberfläche der Substrate aufgedampft wird.

8. Verfahren nach Anspruch 7, **dadurch gekennzeichnet, dass** im zweiten Behandlungsbereich (4, 5) in Abhängigkeit von der in diesem Bereich befindlichen Fläche des Substrats beim Durchlauf dieses Substrats elektrische Energie an das Plasma abgegeben wird und durch den Beschuss mit aus dem Plasma stammenden Ionen an der Oberfläche von flüssigem Zink gestreut wird, das in diesem Behandlungsbereich (4, 5) vorhanden ist.

9. Verfahren nach einem der Ansprüche 1 bis 8, **dadurch gekennzeichnet, dass** die Substrate in Richtung auf den Behandlungsbereich (3, 4, 5) und ausgehend von diesem Bereich durch eine Eingangsvakuumschleuse (2) und eine Austrittvakuumschleuse (6) transportiert werden.

10. Verfahren nach Anspruch 9, **dadurch gekennzeichnet, dass** die Einführung der Substrate in die Eingangsvakuumschleuse (2) und der Austritt aus der Austrittvakuumschleuse (6) mit einer Transportgeschwindigkeit erfolgt, die in Abhängigkeit von einer Behandlungsgeschwindigkeit der Substrate im Behandlungsbereich (3, 4, 5) bestimmt wird und die höher ist als diese Behandlungsgeschwindigkeit.

11. Anlage zur Plasmabehandlung von aufeinanderfolgenden Substraten, umfassend ein oder mehrere Erzeugnisse aus Stahl, wobei diese Anlage mindestens umfasst: eine Plasmabehandlungsvorrichtung (9, 19, 20) mit einem Mantel, in dem ein Behandlungsbereich vorgesehen ist, und Transportmittel (17), um die Substrate durch den Behandlungsbereich der Vorrichtung (9, 19, 20) zu befördern, **dadurch gekennzeichnet, dass** ein Detektor (15, 16, 28, 29) am Eingang und am Ausgang der Behandlungsvorrichtung (9, 19,20) vorgesehen ist, wobei diese Detektoren (15, 16, 28, 29) über ein Slave-Programm mit einer Quelle für elektrische Energie zusammenarbeiten, die bereitgestellt wird, um im Behandlungsbereich in Abhängigkeit von der in diesem Behandlungsbereich befindlichen Fläche des Substrats ein Plasma zu erzeugen, wenn das Substrat durch diesen Bereich läuft.

12. Anlage nach Anspruch 11, **dadurch gekennzeichnet, dass** sie umfasst: eine erste Behandlungsvorrichtung (9), die ein Vakuumgefäß (8) mit einer Plasma-Ionenquelle aufweist, die es ermöglicht, die Oberfläche der Substrate zu aktivieren, gefolgt von mindestens einer zweiten Behandlungsvorrichtung (19, 20) mit einem Verzinkungs-Vakuumgefäß (11, 13), das die Galvanisierung der Substrate ermöglicht.

13. Anlage nach Anspruch 12, **dadurch gekennzeichnet, dass** stromaufwärts von der ersten Vorrichtung (9) eine Eingangsvakuumschleuse (2) vorgesehen ist, die durch eine dichte Tür (14) vom Gefäß (8) der ersten Vorrichtung (9) getrennt ist, wobei im Gefäß (8) stromaufwärts vom Behandlungsbereich der ersten Vorrichtung (9) ein Substrateintritt-Detektor (15) vorgesehen ist und im Gefäß (8) stromabwärts von diesem Behandlungsbereich ein Substrataustritt-Detektor (16) montiert ist.

14. Anlage nach Anspruch 13, **dadurch gekennzeichnet, dass** die Eingangsvakuumschleuse (2) einen Detektor (33) umfasst, der es ermöglicht, das Eintreffen eines Substrats am Ort der dichten Tür (14) festzustellen.

15. Anlage nach einem der Ansprüche 12 bis 14, **dadurch gekennzeichnet, dass** das Verzinkungs-Vakuumgefäß (10, 13) der zweiten Vorrichtung (19, 20) umfasst: einen Mantel (25) zum Einschluss des Zinkdampfes, in dem sich ein Schmelztiegel (23) mit flüssigem Zink befindet, und Mittel zur Erzeugung eines Plasmas im Behandlungsbereich im Inneren dieses Mantels (25), die es ermöglichen, durch eine Streuung der Energie des Plasmas an der Oberfläche des flüssigen Zinks in dem Schmelztiegel (23) Zinkdampf zu erzeugen, wobei ein Substrateintritt-Detektor (28) in dem Verzinkungs-Vakuumgefäß (11,13) stromaufwärts von dem Einschlussmantel (25) vorgesehen ist und ein Substrataustritt-Detektor (29) in diesem Gefäß (11, 13) stromabwärts vom Mantel (25) montiert ist.

16. Anlage nach Anspruch 15, **dadurch gekennzeichnet, dass** der Schmelztiegel (23) über ein Rohr (24) mit flüssigem Zink gespeist wird, und zwar ausgehend von einem Ofen (22), der in einem Vakuumgefäß (21) angeordnet ist, das vom Verzinkungs-Vakuumgefäß (11, 13) getrennt ist, wobei der Ofen (22) Zink enthält, das mindestens teilweise in geschmolzenem Zustand gehalten wird und in das ein Ende des Rohrs (24) eingetaucht ist.

17. Anlage nach einem der Ansprüche 12 bis 16, **dadurch gekennzeichnet, dass** auf das Verzinkungs-Vakuumgefäß (11, 13) eine Austrittvakuumschleuse (6) folgt, die von dem Verzinkungsgefäß (11, 13) durch eine dichte Tür (14) getrennt ist.

18. Anlage nach Anspruch 17, **dadurch gekennzeichnet, dass** die Austrittvakuumschleuse (6) einen Detektor umfasst, der es ermöglicht, den vollständigen Durchgang des Substrats durch die dichte Tür (14) der zweiten Vorrichtung (19, 20) zu erkennen.

19. Anlage nach einem der Ansprüche 12 bis 18, **dadurch gekennzeichnet, dass** ein Transportgefäß (10, 12) zwischen der ersten (9) und der zweiten Vorrichtung (19, 20) vorgesehen ist, das Mittel umfasst, um die Substrate durch die Behandlungsbereiche der ersten und der zweiten Vorrichtung laufen zu lassen.

20. Anlage nach einem der Ansprüche 12 bis 19, **dadurch gekennzeichnet, dass** sich vor oder nach dem Verzinkungs-Vakuumgefäß (11, 13) ein Transportgefäß (10, 12) befindet, das Antriebsmittel (17) aufweist, um die Substrate durch das Verzinkungs-Vakuumgefäß (11, 13) laufen zu lassen.

21. Anlage nach einem der Ansprüche 12 bis 20, **dadurch gekennzeichnet, dass** die Behälter (8, 10, 11, 12, 13) einen Tisch umfassen, auf dem ein oberer glockenförmiger Teil des betroffenen Gefäßes angeordnet ist, der vollständig entfernt oder angehoben werden kann, um Zugang zu den im Inneren des Gefäßes befindlichen Einrichtungen zu verschaffen.

22. Anlage nach einem der Ansprüche 12 bis 21, **dadurch gekennzeichnet, dass** das Verzinkungs-Vakuumgefäß (11, 13) mit einem oder mehreren benachbarten Gefäßen (10, 12) durch eine biegsame und dichte Verbindung in Form eines Schlauches (18) verbunden ist, der den Durchgang der Substrate durch diese Verbindung zwischen den aufeinanderfolgenden Gefäßen ermöglicht.

23. Anlage nach einem der Ansprüche 11 bis 22, **dadurch gekennzeichnet, dass** sie ein Master-Programm umfasst, das den Durchlauf der Substrate in Abhängigkeit vom Vorhandensein der physikalischen Bedingungen steuert, die vor der Erzeugung eines Plasmas in der Plasmabehandlungsvorrichtung (9, 19, 20) notwendig sind, wobei jeder Plasmabehandlungsvorrichtung ein Slave-Programm zugeordnet ist und dem Master-Programm untergeordnet ist, wobei dieses Slave-Programm mit den Eintritt- (15, 28) und Austrittdetektoren (16, 29) zusammenarbeitet, um die das Plasma erzeugende elektrische Energie in Abhängigkeit vom Signal der Eintritt- (15, 28) und Austrittdetektoren (16, 29) derart zu regeln, dass die in das Plasma eingekoppelte Energie proportional zur Fläche des Substrats steigt, wenn der Eintrittdetektor (15, 28) ein Substrat erkennt und wenn von dem Austrittdetektor (16, 29) kein Substrat erkannt wird, dass die Energie den Nennwert aufweist, wenn der Eintrittdetektor (15, 28) und der Austrittdetektor (16, 29) dieses Substrat erkennen, und dass diese Energie proportional zur Fläche des Substrats verringert wird, die sich zwischen dem Eintrittdetektor (15, 28) und dem Austrittdetektor (16, 29) befindet, wenn nur der Austrittdetektor (16, 29) das Vorhandensein des Substrats erkennt.
